# EUROPÄISCHE PATENTSCHRIFT

(11) **EP 1 608 794 B1**
(45) Veröffentlichungstag und Bekanntmachung des Hinweises auf die Patenterteilung: **16.09.2009**
(21) Anmeldenummer: 04713004.2
(22) Anmeldetag: 20.02.2004
(51) Int. Cl.: C23C 16/455, C23C 16/44, C23C 16/30, C23C 16/40

(54) **VORRICHTUNG ZUR ABSCHEIDUNG VON VERBINDUNGEN AUF EINEM SUBSTRAT MITTELS METALLORGANISCHER GASPHASENDEPOSITION**
APPARATUS FOR DEPOSITING COMPOUNDS ON A SUBSTRATE BY MEANS OF METALORGANIC CHEMICAL VAPOR DEPOSITION
DISPOSITIF POUR DEPOSER DES COMPOSES SUR UN SUBSTRAT PAR DEPOSITION ORGANOMETALLIQUE EN PHASE GAZEUSE

(30) Priorität: 21.03.2003 DE 10312768; 06.06.2003 DE 10325629
(43) Veröffentlichungstag der Anmeldung: 28.12.2005
(73) Patentinhaber: Forschungszentrum Jülich GmbH, 52425 Jülich (DE)
(72) Erfinder: HARDTDEGEN, Hilde, 52064 Aahen (DE); SCHMIDT, Roland, 07745 Jena (DE); KALUZA, Nicoleta, 41199 Mönchengladbach (DE); WIRTZ, Konrad, 52499 Baesweiler (DE); MAKAROV, Yuri, 91058 Erlangen (DE)
(86) Internationale Anmeldenummer: PCT/DE2004/000315
(87) Internationale Veröffentlichungsnummer: WO 2004/085702

(56) Entgegenhaltungen:
- EP-A- 1 108 468
- EP-A- 1 207 215
- DE-A- 10 118 130
- US-A- 5 494 521
- US-A1- 2001 021 593

## Beschreibung

Die Erfindung betrifft eine Vorrichtung zur Abscheidung von Verbindungen auf einem Substrat mittels metallorganischer Gasphasendeposition.

Die metallorganische Gasphasendeposition (metal organic chemical vapor deposition: MOCVD) ist ein Verfahren zur Herstellung komplex aufgebauter Schichtstrukturen, wie sie in Bauelementen, z.B. Lasern, Hochgeschwindigkeitstransistoren für Handys oder Leuchtdioden verwendet werden. Im Gegensatz zum bekannten Silizium bestehen diese Strukturen nicht nur aus einem, sondern aus zwei oder auch mehr Elementen. Sie werden daher auch als Verbindungshalbleiter bezeichnet. Die metallorganische Gasphasendeposition findet in einer sogenannten MOCVD-Anlage statt.

Mit der MOCVD-Anlage können unter anderem Nitridschichten abgeschieden werden, die aus zwei Elementen, wie z.B. GaN, InN oder AlN oder aus mehreren Elementen, wie z.B. GaInN oder AlGaN bestehen. Diese Verbindungen werden als binäre bzw. ternäre Systeme bezeichnet. Für die einkristalline Abscheidung von Nitrid-Verbindungen werden Saphir (Al₂O₃) oder Siliziumcarbid (SiC) oder Silizium, die ähnliche Kristalleigenschaften wie die Nitride aufweisen, als Substrate verwendet.

Die Gruppe III-Nitride, spannen durch ihre Vertreter ein Halbleitersystem mit direkter Bandlücke von 1,9 eV für das InN bis 6,2 eV für das AlN auf.
Diese Nitridschichten sind wirtschaftlich sehr bedeutsam, da sie durch elektrische Anregung den blauen Teil des sichtbaren Spektrums entsenden können und daher zur Realisierung optoelektronischer Bauelemente in dem entsprechenden Energiebereich nutzbar gemacht werden. Als ein Beispiel hierfür seien pn-Leuchtdioden auf Basis von GaN genannt.

Zur metallorganischen Gasphasendeposition von Nitridschichten benötigt man gasförmige Verbindungen von Gallium, Indium oder Aluminium sowie NH₃ als sogenannte Precursor. Im Falle von Gallium wird eine metallorganische Verbindung, z.B. Trimethylgallium (TMG), verwendet. Mittels eines Trägergases, z.B. Wasserstoff, werden die Precursor in einen Reaktionsraum der Anlage eingebracht. Dort befindet sich das Substrat, eine einkristalline, sehr dünne Scheibe (Wafer), die erhitzt wird. Der Wafer ist auf einem sogenannten Suszeptor drehbar gelagert, um eine gleichmäßige Verteilung von Temperatur und Precursor in der Gasphase über dem Substrat zu erzielen. Über Infrarotstrahler oder eine Hochfrequenzheizung werden der Suszeptor und das Substrat geheizt. Die Temperatur am Substrat reicht bis ca. 1500°C, je nachdem, welches Materialsystem abgeschieden wird. Dieser Bereich wird auch als heiße Zone bezeichnet.

Zur Abscheidung auf dem Substrat, werden die Precursor umgesetzt. Dies geschieht zum Teil schon in der Gasphase durch die Hitze, die vom Substrat ausgeht, oder durch Zusammenstöße mit den Molekülen des Trägergases. Die Molekül-Bruchstücke setzen sich auf der Substratoberfläche ab. Infolge der hohen Temperatur zersetzen sich die ursprünglichen Precursorverbindungen und reagieren je nach eingesetzten Edukten neu, z.B. zu GaN, InN oder AlN. Auf diese Weise wächst auf dem Wafer Atomlage für Atomlage eine neue Schicht aus GaN, InN oder AlN auf. Die Reste der Ausgangsmoleküle, beispielsweise Methylgruppen vom TMG und Wasserstoff, verbinden sich teilweise miteinander zu Methan. Nicht abgeschiedene Moleküle und Molekülbruchstücke lösen sich von der Oberfläche, werden wie das Methan vom Trägergasstrom erfaßt und aus der MOCVD-Anlage in ein Gasreinigungssystem, den sogenannten Scrubber gespült.

MOCVD-Anlagen weisen hierzu zwei Gaseinlässe und Möglichkeiten zur Teilung der einzuleitenden Gasströme auf, da eine sofortige Mischung innerhalb der Anlage wegen der Bildung von Säure-Base-Addukten häufig unerwünscht ist. Hierzu ist eine Teilerplatte hinter den Gaseinlässen der Anlage derartig angeordnet, daß die MOCVD-Anlage in einen oberen und einen unteren Raum kompartimentiert wird. Außerhalb der Anlage sind Gassammelleitungen angeordnet, die zu den Vorratsbehältern führen. In diesen Vorratsbehältern werden die Ausgangsstoffe, also einerseits Metallorganika und andererseits Gruppe V- oder Gruppe VI-Verbindungen, aufbewahrt.

Bei der verfahrenstechnischen Herstellung von z.B. Gruppe-III-Nitridschichten mittels Gasphasendeposition in MOCVD-Anlagen werden die Precursor somit mittels ihrer Trägergase (H₂, N₂, Argon) jeweils separat in die Anlage eingeleitet. Die Gasströme werden erst in der heißen Zone der Anlage gemischt. Um die Stabilisierung der Nitrid-Oberfläche zu gewährleisten, an der bevorzugt bei Wachstumstemperatur der Stickstoff inkongruent verdampft, wird das Trägergas/NH₃-Gemisch (Gruppe V-Verbindung) gemäß Stand der Technik örtlich gesehen näher zur Wachstumsoberfläche auf dem Substrat eingebracht als das Trägergas/Metallorganikum-Gemisch. Dies hat zur Folge, dass durch die heiße Oberfläche des Substrats Stickstoff aus Ammoniak freigesetzt wird und für die Reaktion auf dem Substrat zur Verfügung steht. Diese Vorgehensweise wird auch für Abscheidungen anderer Verbindungen gewählt.

Nachteilig lagern sich im genannten Fall die gebildeten Nitride aber als parasitäre Depositionen auch an den heißen Wänden der Anlage rasch ab. Die Beschaffenheit und die Dicke der Depositionen ändern sich im Laufe des Verfahrens. Die Depositionen verändern das Wachstum auf dem Substrat durch katalytische Zerlegung der Ausgangsverbindungen und verursachen eine Verarmung in der Gasphase. Da die abgeschiedenen Verbindungen dunkel gefärbt sind, beeinflußt dies die Gasphasen- und die Oberflächentemperatur über dem Substrat. Die Nitridschichten können daher nicht reproduzierbar auf dem Substrat abgeschieden werden.

Die parasitäre Deposition blättert zudem nach kurzer Zeit ab. Die Partikel fallen von mit parasitärer Deposition belegten Bauteilen der Anlage auf das Substrat bzw. die Probe und beeinflussen nachteilig die Eigenschaften der dort aufgebrachten Schicht (en).

Als Lösung dieser Probleme könnten die mit parasitärer Deposition belegten Bauteile der Anlage, die mit dem Substrat in Verbindung stehen, ausgetauscht oder gereinigt werden, sobald sich dort eine kritische parasitäre Deposition abgelagert hat.
Dies ist aber nachteilig teuer, da die Anlage in der Zwischenzeit nicht benutzt werden kann.

US2001/021593 A1 offenbart zur Lösung dieses Problems eine CVD-Anlage und ein CVD-Verfahren zur Abscheidung von Halbleiterfilmen. Dabei wird ein Gasfluss erhalten, bei dem sich Trimethylgallium-H₂-Gemisch zwischen dem Substrat und dem NH₃-H₂-Gemisch befindet.

EP-A-1 207 215 offenbart ein Verfahren zur Herstellung eines III-V-Halbleiterfilms. Dabei wird ein Gasgemisch erhalten, das derart geschichtet ist, dass sich ein Metallorganikum zwischen dem Substrat und der Gruppe V- oder Gruppe VI-Verbindung befindet.

US 5,494,521 offenbart eine MOCVD-Anlage zur Abscheidung von III-V-Halbleiterfilmen.

Nachteilig ist es mit allen bisher im Stand der Technik offenbarten Vorrichtungen nicht möglich, Gase flexibel auf die Kompartimente innerhalb der Anlage zu verteilen.

Aufgabe der Erfindung ist, eine Vorrichtung zur Abscheidung von Verbindungen auf einem Substrat mittels metallorganischer Gasphasendeposition bereit zu stellen, so dass keine parasitäre Deposition auftritt.

Die Aufgabe wird durch eine MOCVD-Anlage mit den Merkmalen nach Patentanspruch 1 gelöst.

Eine erfindungsgemäße MOCVD-Anlage zur flexiblen Umschaltung der Gasgemische weist mindestens zwei Gaseinlässe auf. Einen ersten für ein erstes Gemisch und mindestens einen zweiten für ein weiteres Gemisch. Die Gase selbst befinden sich in Vorratsbehältern. Zwischen den Gaseinlässen der Anlage und den Vorratsbehältern für die Gase sind erfindungsgemäß mindestens zwei Drei-Wege-Ventile in sogenannten Gassammelleitungen angeordnet. Es können aber auch geeignete Schnellverschlusskupplungen angeordnet sein.

Dies bewirkt vorteilhaft, daß die Anlage an die Vorratsbehälter angeschlossen werden kann und die Gase je nach Bedürfnissen flexibel in verschiedene Kompartimente der MOCVD-Anlage eingeleitet werden können, ohne dass die Anlage umständlich von den Vorratsbehältern getrennt und neu verbunden werden muß.
Mit anderen Worten, der Betreiber einer solchen Anlage ist in der Lage, Gase nach seinen Vorstellungen bequem und flexibel in die Teile der Anlage zu leiten, wo sie benötigt werden. Dadurch können die Gaseinlässe für die Gasgemische schnell miteinander vertauscht werden.

Es ist aber auch denkbar, zu diesem Zweck andere bauliche Veränderungen an der Anlage vorzunehmen.

Es ist möglich, bei einem Verfahren ein erstes Gemisch aus mindestens einem Trägergas und mindestens einem Metallorganikum sowie ein zweites Gemisch aus mindestens einem Trägergas und mindestens einer Gruppe V- oder Gruppe VI-Verbindung zu verwenden, wobei beide Gemische separat in eine Anlage zur Abscheidung der Verbindung auf dem Substrat eingeleitet werden. Dabei wird das mindestens eine Metallorganikum zwischen das Substrat und der Gruppe V- oder Gruppe VI-Verbindung eingeleitet.

Das mindestens eine Metallorganikum wird also örtlich gesehen näher an das Substrat geleitet, als die Gruppe V- oder Gruppe VI-Verbindung.

Vorteilhaft wird dadurch bewirkt, daß die Dicke an parasitärer Deposition erheblich vermindert wird, da die Abscheidung nur dort vollzogen wird, wo sie erwünscht ist, nämlich auf dem Substrat. Die Abscheidungsrate wird regelmäßig erhöht und die Schichten sind hochrein im Vergleich zu Schichten, die gemäß Stand der Technik abgeschieden wurden.

Die Partikelbildung an den Wänden und an der Decke der Anlage wird auf ein Minimum reduziert. Es können reproduzierbar viele Schichten abgeschieden werden, ohne dass mit parasitärer Deposition belegte Teile der Anlage aufwendig gewechselt werden müssen und ohne dass abgeschiedene Schichten durch abblätternde Deposition verunreinigt werden.

Als Metallorganikum kann eine Gruppe II- oder eine Gruppe III- oder eine Gruppe IV-Verbindung oder Mischungen hieraus gewählt werden. Nur beispielhaft seien Barium-Strontium-Verbindungen (Gruppe II) oder Trimethylgallium, Trimethylaluminium und Trimethylindium (Gruppe III) oder Titanisopropoxid (Gruppe IV) als Metallorganika genannnt.

Als Gruppe V-Verbindung kann NH₃ und / oder AsH₃ und / oder PH₃ und als Gruppe VI-Verbindungen Sauerstoff oder Diethytellur gewählt werden.

Selbstverständlich ist das Verfahren aber nicht auf die Wahl derartiger Verbindungen eingeschränkt. Vielmehr kann das Verfahren grundsätzlich zur Abscheidung von Verbindungen auf einem Substrat mittels metallorganischer Gasphasendeposition verwendet werden.

Als Trägergas für die Verbindungen kommt Wasserstoff und / oder Stickstoff und / oder Argon in Betracht.

Zur Abscheidung von z.B. GaN kann Trimethylgallium als Gruppe III-Verbindung und NH₃ als Gruppe-V-Verbindung mit jeweils Wasserstoff als Trägergas gewählt werden.
Dabei wird das Metallorganikum/Trägergas-Gemisch zwischen dem Substrat und dem NH₃/Trägergas-Gemisch eingeleitet. Es ist aber ohne Einschränkung der Erfindung möglich, das erfindungsgemäße Verfahren auf andere Verbindungen zu übertragen, um parasitäre Deposition zu vermeiden.

Im Weiteren wird die Erfindung an Hand eines Ausführungsbeispiels und der beigefügten 5 Figuren näher beschrieben.

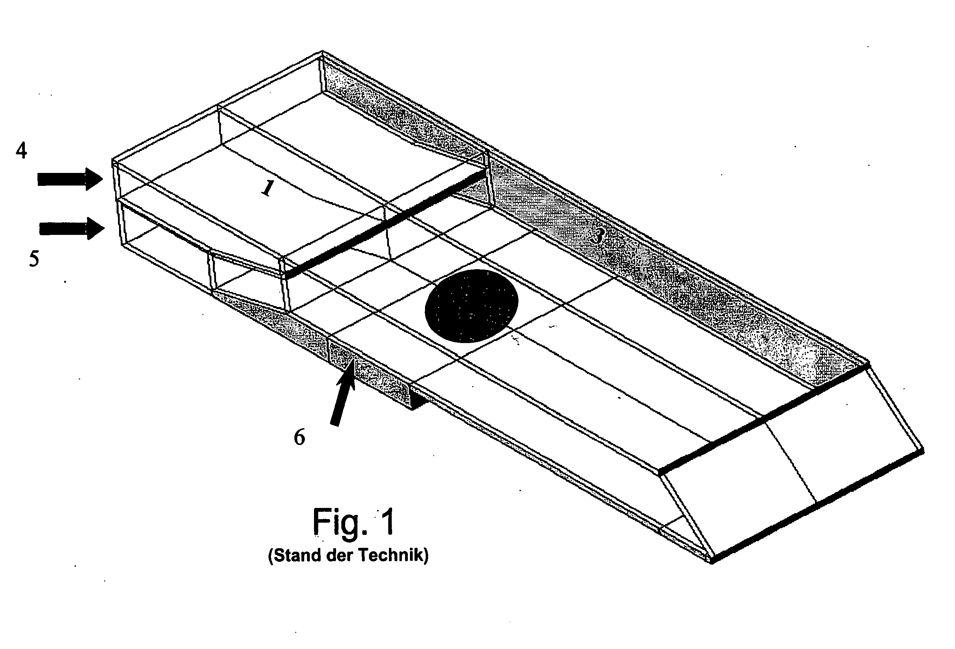

Figur 1 zeigt schematisch eine MOCVD-Anlage gemäß Stand der Technik mit zwei Gaseinlässen 4, 5 für ein oberes und ein unteres Kompartiment. Die Precursor werden durch eine Teilerplatte 1 voneinander getrennt an ein zu beschichtendes Substrat 2 geführt. Die MOCVD-Anlage ist durch die Teilerplatte 1 in einen oberen und einen unteren Raum hinter den Gaseinlässen 4, 5 kompartimentiert. Das Substrat 2 kann beispielsweise ein zwei Zoll-Wafer sein. Selbstverständlich ist das Verfahren aber nicht auf etwaige Größen oder Formen des Substrats eingeschränkt. Das Substrat 2 ist in einem Suszeptor 6 eingebracht, der hier als drehbarer Teller ausgeführt ist. Die Wände der Anlage sind nur angedeutet. Das heißt, dass im vorliegenden Fall nur eine Wand 3 dargestellt wurde. Die in Blickrichtung gesehen vordere Wand sowie die Decke sind nicht dargestellt, um einen Einblick in die Anlage zu gewährleisten.

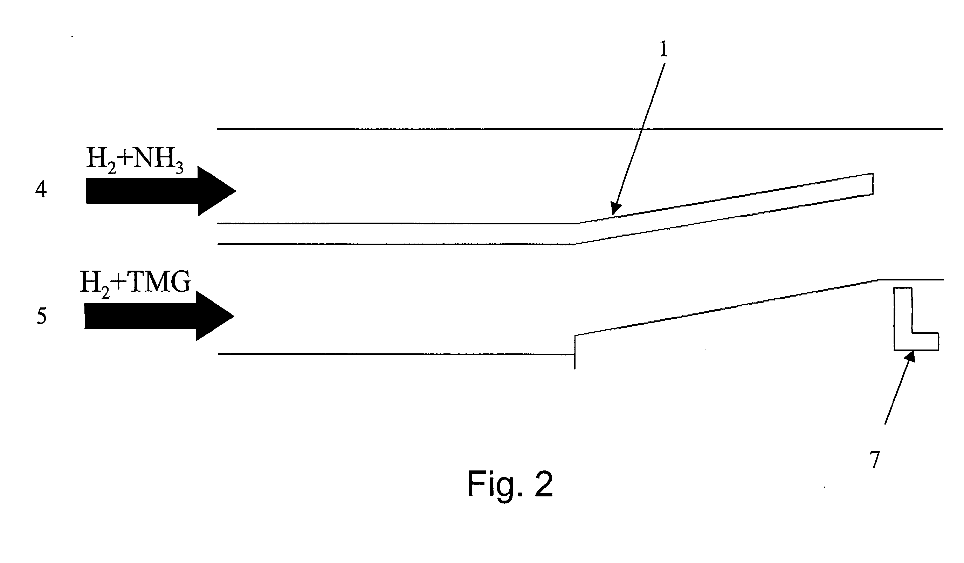

Fig. 2 ist ein Querschnitt durch die Anlage entlang einer gedachten Linie zwischen den Gaseinlässen und einer Kühlung 7 vor dem Suszeptor (nicht dargestellt). Die Kühlung 7 ist in Fig. 2 nur angedeutet. Im vorliegenden Fall wird der Gaseinlass 5 durch das Metallorganikum/Trägergas-Gemisch (TMG/H₂) und der Gaseinlaß 4 durch das NH₃/Trägergasgemisch (NH₃/H₂) belegt. Nach dem Eintritt der Gase in die Anlage bleiben die beiden Gasströme zunächst durch die Teilerplatte 1 voneinander getrennt, bis sie hinter der Teilerplatte 1 vermischt werden und an das Substrat auf dem Suszeptor gelangen. Das Metallorganikum/Trägergas-Gemisch wird zwischen das Substrat und das NH₃/Trägergasgemisch geleitet.

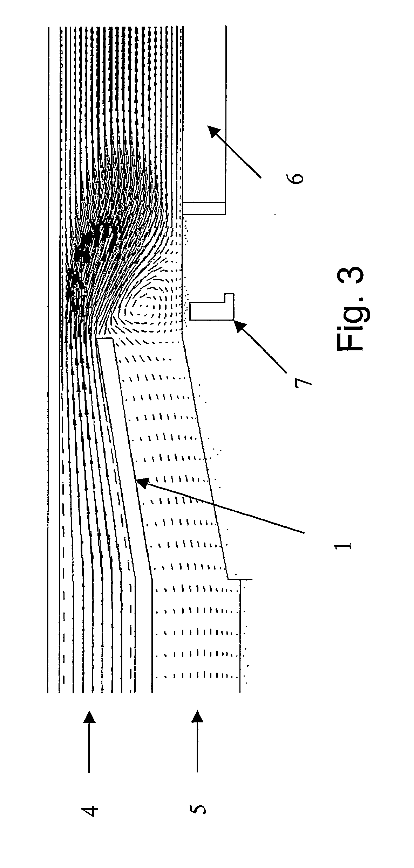

Fig. 3 zeigt die Vermischung der Reaktanden oberhalb der angedeuteten Kühlung 7 kurz vor dem Suszeptor 6. Das dichtere Ammoniak/Trägergas-Gasgemisch diffundiert in Richtung des Substrats auf dem Suszeptor 6, wo es sich mit dem Metallorganikum/Trägergasgemisch vermischt. Auf und vor dem Substrat, das die Zerlegung der Precursor katalytisch beschleunigt, kommt es zur Abscheidung von GaN. Die Gesamtgasmischung erreicht nicht die Decke der Anlage, so dass dort die parasitäre Deposition an GaN vermieden wird.

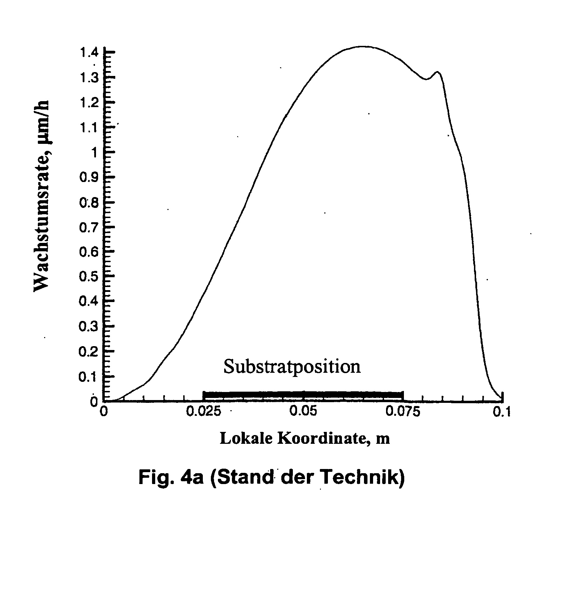

Fig. 4a stellt den Verlauf der Abscheidungen von GaN dar, wie sie im Stand der Technik auftritt. Die X-Achse zeigt die lokalen Koordinaten entlang eines Substrates bzw. eines Wafers. Der Wafer ist durch den schwarzen Balken angedeutet. Die Abscheidungsrate beträgt nach einer Stunde nur ca. 1,3 Mikrometer GaN.

Das hier vorgestellte Verfahren, bei dem das TMG/H₂-Gemisch zwischen dem Substrat und dem NH₃/Trägergasgemisch, also örtlich gesehen näher an das Substrat ein geleitet wird, ermöglicht eine durchschnittlich viel höhere Abscheidungsrate von ca. 4 bis 5 Mikrometer GaN. Auf Grund des drehbaren Suszeptors 6 vollzieht sich die Abscheidung gleichmäßig auf dem Wafer . Die hohen Abscheidungsraten vor dem Wafer ermöglichen eine Abscheidung von GaN mit sehr hoher Reinheit auf diesem Wafer.

Die hohe Abscheidungsrate kommt im letzteren Fall dadurch zustande, dass die Gasphase nicht durch parasitäre Deposition an den Anlagenwänden verarmt. Die Gase stehen also der Abscheidung auf dem Substrat zur Verfügung.

Die in den Figuren 2 bis 4 dargestellte Abscheidung von GaN ist nur beispielhaft.

Als ein weiteres Beispiel für das Verfahren sei die Abscheidung von Zinktellurid genannt. Dabei wird zwischen Substrat und der Gruppe VI-Verbindung Diethyltellur die Gruppe II-Verbindung Dimethylzink in die Anlage eingeleitet.

Es ist auch möglich, zur Abscheidung für das Dielektrikum (Ba, Sr)-Titanat ein Gemisch aus zwei oder drei Metallorganika zwischen Sauerstoff und dem Substrat in die Anlage einzuleiten. Die Metallorganika umfassen z.B. ein Gemisch aus Diketonaten des Barium und Strontium sowie Alkoxiden des Titan, z.B. Titanisopropoxid. Dabei wird zwischen Substrat und Sauerstoff als Gruppe VI-Verbindung das Gemisch aus Metallorganika in die Anlage eingeleitet.

Es ist darüber hinaus möglich zur Herstellung der jeweiligen Schichtverbindungen jeweils geeignete Kombinationen von Metallorganika und Gruppe V- bzw. Gruppe VI-Verbindungen, wie in Tab. 1 angegeben, auszuwählen.

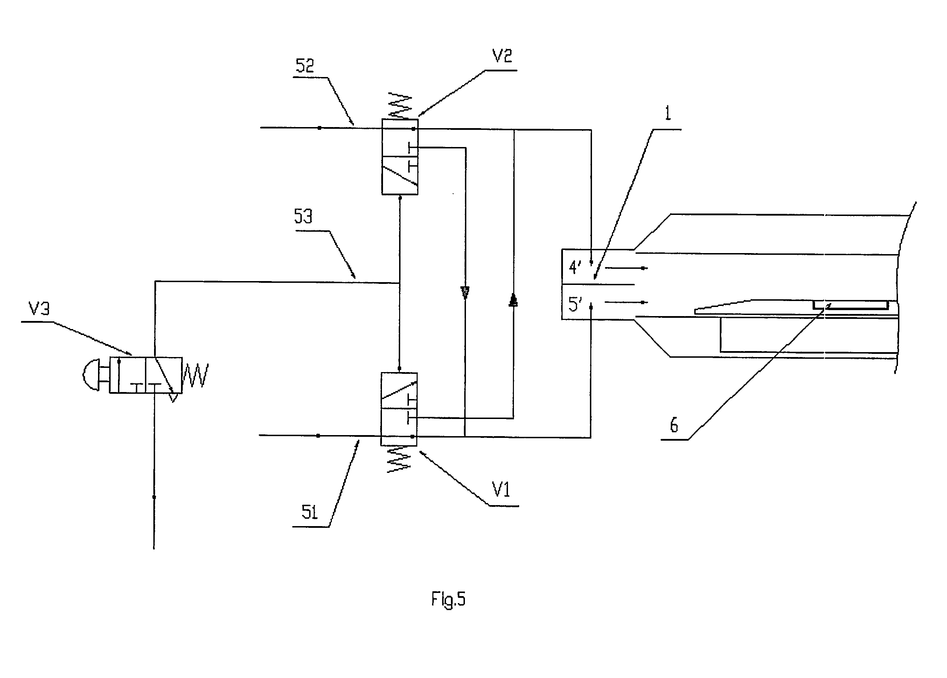

Fig. 5 zeigt die erfindungsgemäße Vorrichtung für die flexible Umschaltung der Gaseinlässe einer MOCVD-Anlage.

Die Sammelleitung 52 ist mit einem Vorratsbehälter (nicht dargestellt) für ein Trägergas/Metallorganikum-Gasgemisch verbunden und wird auf das pneumatische 3/2-Wege-Ventil V2 geführt. Die Sammelleitung 51 ist mit einem Vorratsbehälter für ein Trägergas/Gruppe V- oder Gruppe VI-Gasgemisch verbunden und wird auf das pneumatische 3/2-Wege-Ventil V1 geführt. Die Ventile V1 und V2 sind über die Leitungen mit dem oberen Kompartiment 4' und dem unteren Kompartiment 5' der Gaseinlässe verbunden. Im drucklosen Zustand ist V2 zum oberen Kompartiment 4' und V1 zum unteren Kompartiment 5' hin geöffnet (s. Fig. 5). Die Gase werden wie im Stand der Technik in die Anlage geleitet.

Beide Ventile V1 und V2 werden mit nur einer N₂-Druckleitung 53 über ein handbetriebenes Ventil V3 umgeschaltet. Das Gemisch aus Trägergas(en) und mindestens einem Metallorganikum wird dann unter Druck in Kompartiment 5' geleitet, also zwischen einem Substrat auf einem Suszeptor 6 und einem Gemisch aus Trägergas(en) und mindestens einer Gruppe V oder Gruppe VI-Verbindung. Letztgenanntes Gasgemisch wird dann in Kompartiment 4' geleitet. Die Teilerplatte 1 ist in Fig. 5 nur angedeutet und führt wie in den Figuren 1 bis 3 gezeigt fast bis zum Suszeptor 6.

Somit ist gewährleistet, dass niemals die unterschiedlichen Gasgemische gleichzeitig auf ein und dasselbe Kompartiment 4', 5' gegeben werden können. Eine derartige Verbesserung erlaubt eine sichere und zugleich flexible Zuleitung der Gasgemische in das obere und untere Kompartiment 4', 5' der Anlage.

Teileliste:
- 3/2-Wegeventile (V1, V2): 1/4 Zoll VCR-FFF
- 3/2-Wegeventil (V3) handbetätigt, Schalttafel-Einbauventil (Bosch) 0820 402 024 3/2 WV NG4 (1/8 Zoll)
- Edelstahlrohr 1/8 Zoll elektropoliert
- Pneumatikschlauch 1/8 Zoll

**Tabelle 1**

| **Schichtverbindung** | **Metallorganikum** | **Gruppe V- / Gruppe VI-Verbindung** | **Trägergas** |
|---|---|---|---|
| Aluminiumgalliumarsenid ((AlGa)As) | TMAl (Trimethylaluminium), TEAl (Triethylaluminium), TMGa (Trimethylgallium), TEGa (Triethylgallium | AsH₃ (Arsin), TBAs (Tertiärbutylarsin) | H₂, N₂, Ar |
| Galliumarsenid (GaAs) | TMGa, TEGa | AsH₃, TBAs | H₂, N₂, Ar |
| Aluminiumarsenid (AlAs) | TMAl, TEAl | AsH₃, TBAs | H₂, N₂, Ar |
| Galliumindiumarsenid ((Galn)As) | TMGa, TEGa, TMln | AsH₃, TBAs | H₂, N₂, Ar |
| Aluminiumindiumarsenid ((Alln)As) | TMAl, TEAl, TMln | AsH₃, TBAs | H₂, N₂, Ar |
| Indiumphosphid (InP) | TMln | PH₃, TBP | H₂, N₂, Ar |
| Aluminiumgalliumindium-phosphid ((AlGaln)P) | TMAl, TEAl, TMGa, TEGa, TMln (Trimethylindium) | PH₃ (Phosphin), TBP (Tertiärbutylphosphin) | H₂, N₂, Ar |
| Galliumindiumphosphid ((Galn)P) | TMGa, TEGa, TMIn | PH₃, TBP | H₂, N₂, Ar |
| Aluminiumindiumphosphid ((Alln)P) | TMAI, TEAI, TMln | PH₃, TBP | H₂, N₂, Ar |
| Galliumindiumarsenidphosphid ((Galn)(AsP)) | TMGa, TEGa, TMln | AsH₃, TBAs, PH₃, TBP | H₂, N₂, Ar |
| Aluminiumgalliumindiumarsenid- ((AlGaln)(ASP)) | TMAl, TEAl, TMGa, TEGa, TMln phosphid | AsH₃, TBAs, PH₃, TBP | H₂, N₂, Ar |
| Aluminiumnitrid (AlN) | TMAl, TEAl | NH₃ (Ammoniak) | H₂, N₂, Ar |
| Galliumnitrid (GaN) | TMGa, TEGa | NH₃ | H₂, N₂, Ar |
| Indiumnitrid (InN) | TMln | NH₃ | H₂, N₂, Ar |
| Aluminiumgalliumindiumnitrid ((AlGaln)N) | TMAl, TEAl, TMGa, TEGa, TMln | NH₃ | H₂, N₂, Ar |
| Galliumindiumnitrid ((Galn)N) | TMGa, TEGa, TMln | NH₃ | H₂, N₂, Ar |
| Galliumantimonid (GaSb) | TMGa, TEGa | TMSb (Trimethylantimon), TESb (Triethylantimon) | H₂, N₂, Ar |
| Aluminiumantimonid (AlSb) | TMAl, TEAI | TMSb, TESb . | H₂, N₂, Ar |
| Indiumantimonid (InSb) | TMIn | TMSb, TESb | H₂, N₂, Ar |
| Aluminiumindiumantimonid ((Alln)Sb) | TMAl, TEAl, TMIn | TMSb, TESb | H₂, N₂, Ar |
| Galliumindiumantimonid ((Galn)Sb)) | TMGa, TEGa, TMln | TMSb, TESb | H₂, N₂, Ar |
| Galliumarsenidantimonid (Ga(AsSb)) | TMGa, TEGa | AsH₃, TBAs, TMSb, TESb | H₂, N₂, Ar |
| Aluminiumarsenidantimonid (Al(AsSb)) | TMAl, TEAl | AsH₃, TBAs, TMSb, TESb | H₂, N₂, Ar |
| Indiumarsenidantimonid (In(AsSb)) | TMIn | AsH₃, TBAs, TMSb, TESb | H₂, N₂, Ar |
| Galliumindiumarsenidantimonid ((Galn)(AsSb)) | TMGa, TEGa, TMln | AsH₃, TBAs, TMSb, TESb | H₂, N₂, Ar |
| Galliumphosphidantimonid (Ga(PSb)) | TMGa, TEGa | PH₃, TBP, TMSb, TESb | H₂, N₂, Ar |
| Indiumphosphidantimonid (In(PSb)) | TMIn | PH₃, TBP, TMSb, TESb | H₂, N₂, Ar |
| Indiumphosphidarsenid-antimonid (In(PAsSb)) | TMIn | PH₃, TBP, AsH₃, TBAs, TMSb, TESb | H₂, N₂, Ar |
| Cadmiumtellurid (CdTe) | DMCd (Dimethylcadmium) | DETe (Diethyltellur), DMTe (Dimethyltellur), DIPte (Diisopropyltellur) | H₂, N₂, Ar |
| Quecksilbertellurid (HgTe) | Hg (Quecksilber) | DETe | H₂, N₂, Ar |
| Cadmiumquecksilbertellurid ((CdHg)Te) | DMCd, Hg | DETe | H₂, N₂, Ar |
| Zinksulfid (ZnS) | DMZn (Dimethylzink), DEZn (Diethylzink) | H₂S (Schwefelwasserstoff), DES (Diethylschwefel), DTBS (Ditertiärbutylschwefel) | H₂, N₂, Ar |
| Zinkselenid (ZnSe) | DMZn (Dimethylzink), DEZn (Diethylzink) | DMSe (Dimethylselen), DESe (Diethylselen), DIPSe (Diisopropylselen), DTBSe (Ditertiärbutylselen) | H₂, N₂, Ar |
| Bariumstrontiumtitanat ((BaSr)TiO₃) | Ba(thd)₂, Sr(thd)₂, (Barium/Strontiumtetramethyl-heptandionat), Ba(hfa)₂, Sr(hfa)₂, (Barium/Strontiumhexafluoroacetylacetonat), TIP (Titantetrakisisopropoxid), TTB (Titantetrakistertiärbutoxid), | O₂ (Sauerstoff), O₃ (Ozon), N₂O (Lachgas) | N₂, Ar |
| Bleizirkonattitanat (Pb(ZrTi)O₃) | TEL (Tetraethylblei), TBL (Tetraphenylblei) Pb(thd)₂ (Bleitetramethylheptandionat), ZTB (Zirkontetrakistertiärbutoxid), ZIP (Zirkontetrakisisopropoxid), TIP, TTB | O₂ (Sauerstoff), O₃ (Ozon), N₂O (Lachgas) | |
| Bariumtitanat (BaTiO₃) | Ba(thd)₂, Ba(hfa)₂, TIP, TTB | O₂ (Sauerstoff), O₃ (Ozon), N₂O (Lachgas) | |
| Bleibariumtitanat ((PbBa)TiO₃) | TEL, TBL, Pb(thd)₂, Ba(thd)₂, Ba(hfa)₂, TIP, TTB | O₂ (Sauerstoff), O₃ (Ozon), N₂O (Lachgas) | |
| Bleibariumzirkonattitanat ((PbBa)(ZrTi)O₃) | TEL, TBL, Pb(thd)₂, Ba(thd)₂, ZTB, ZIP, Ba(hfa)₂, TIP, TTB | O₂ (Sauerstoff), O₃ (Ozon), N₂O (Lachgas) | |
| Hafniumoxid (HfO₂) | Hf(NR¹R²)₄ (Hafniumamides) z.B.: Hafniumdimethylamid, Hafniumdiethylamid, Hafniummethylethylamid; Hf(OR)₄ (Hafniumalkoxides) z.B: Hafniummethoxid, Hafniumtertärbutoxid Hf(ONR₂)₄(Hafniumhydroxylamid) z.B. Hafniumhydoxyldiethylamid; Hf(O^{t}Bu)₂(mmp)₂ Hafniumditertiätbutyloxid-di(1-methoxy-2-methyl-2-propanolat und Hf(mmp)₄: Hafnium tetra-(1-methoxy-2-methyl-2-propanolat) | O₂ (Sauerstoff), N₂O (Lachgas) | |

## Patentansprüche

1. MOCVD-Anlage für die Gasphasendeposition mit mindestens zwei Gaseinlässen (4,5) für die aus Vorratsbehältern in die Anlage einzuleitenden Gase sowie einer Teilerplatte (1) zur Kompartimentierung der Anlage in zwei Kompartimente (4',5') wobei ein Gasgemisch in das eine Kompartiment (4') und ein anderes Gasgemisch in das andere Kompartiment (5') eingeleitet wird,
**gekennzeichnet durch**
mindestens zwei Drei-Wege-Ventile (V1, V2) in den Gassammelleitungen (S1,S2) zwischen den Gaseinlässen (4,5) der Anlage und den Vorratsbehältern für die Gase, wobei die Gaseinlässe (4,5) über die Drei- Wege-Ventile (V1,V2) an die Vorratsbehälter für die Gase angeschlossen werden können und die Gaseinlässe (4,5) der Anlage für die Gasgemische über die Ventile (V1, V2) vertauscht werden können.

## Claims

1. MOCVD unit for chemical vapour deposition with at least two gas inlets (4, 5) for the gases being introduced into the unit from storage containers and a divider plate (1) for compartmentalisation of the unit into two compartments (4', 5'), in which a gas mixture is introduced into one compartment (4') and another gas mixture is introduced into the other compartment (5'),
**characterised by**
at least two three way valves (V1, V2) in the gas collection pipes (51, 52) between the gas inlets (4, 5) of the unit and the storage containers for the gases, in which the gas inlets (4, 5) may be connected through the three way valves (V1, V2) to the storage containers for the gases and the gas inlets (4, 5) of the unit for the gas mixtures may be changed through the valves (V1, V2).

## Revendications

1. Installation MOCVD pour le dépôt en phase gazeuse comportant au moins deux entrées de gaz (4,5) pour des gaz devant entrer dans l'installation à partir de réservoirs ainsi qu'un plateau de répartition (1) destiné à compartimenter l'installation en deux compartiments (4', 5'), un mélange gazeux étant introduit dans le premier compartiment (4') et un autre mélange gazeux étant introduit dans le deuxième compartiment (5'),
**caractérisée par**
au moins deux vannes trois voies (V1, V2) dans les conduites collectrices de gaz (51, 52) entre les entrées de gaz (4, 5) de l'installation et les réservoirs destinés aux gaz, les entrées de gaz (4, 5) pouvant être reliées aux réservoirs destinés aux gaz via les vannes trois voies (V1, V2) et les entrées de gaz (4, 5) de l'installation destinées aux mélanges gazeux pouvant être permutées grâce aux vannes (V1, V2).
